# EUROPÄISCHE PATENTSCHRIFT

(11) **EP 0 505 822 B1**
(45) Veröffentlichungstag und Bekanntmachung des Hinweises auf die Patenterteilung: **28.09.1994**
(21) Anmeldenummer: 92104065.5
(22) Anmeldetag: 10.03.1992
(51) Int. Cl.: H05K 7/20

(54) **Baugruppenträger mit Führungsschienen**
Component carrier with guide rails
Châssis équipé avec rail de guidage

(30) Priorität: 27.03.1991 DE 9103734 U
(43) Veröffentlichungstag der Anmeldung: 30.09.1992
(73) Patentinhaber: Alcatel SEL Aktiengesellschaft, D-70435 Stuttgart (DE); ALCATEL N.V., NL-1077 XX Amsterdam (NL)
(72) Erfinder: Hüeber, Fritz, W-7143 Vaihingen/Enz (DE)
(74) Vertreter: Pohl, Herbert, Dipl.-Ing.

(56) Entgegenhaltungen:
- EP-A- 0 289 686
- EP-B- 0 145 212
- DE-A- 3 044 314
- DE-A- 3 522 127

## Beschreibung

Die Erfindung betrifft einen Baugruppenträger mit Führungsschienen nach dem Oberbegriff des Anspruchs 1.

In der EP 0 289 686 A1 ist eine Aufnahme für steckbare, mit einer plattenförmigen Wärmesenke flächig verbundene Leiterplatten-Baugruppen beschrieben, wobei die Wärmesenke die Leiterplatte an zwei Kanten überragt und damit zugleich als Führung in Führungsschienen, die paarweise in der Aufnahme angebracht sind, benutzt werden kann. Um einen guten Wärmeübergang von der Wärmesenke auf die Führungsschienen und damit auf den die Aufnahme bildenden Baugruppenträger zu erzielen, ist jede Führungsschiene mit einer Andrückvorrichtung ausgestattet, die jeweils eine Seite der Führungsnut bildet und aus mehreren trapezförmigen Druckstücken besteht. Letztere sind durch ein Spannelement keilartig gegeneinander verschiebbar, wobei sie abwechselnd gegen die Wärmesenke bzw. gegen die Seitenwand der Nut gedrückt werden. Das Spannelement ist eine in Richtung der Führungsnut wirkende Schraube, die am hinteren Ende in die Führungsschiene geschraubt wird und am letzten Druckstück angreift. Am vorderen Ende ist eine Druckfeder eingesetzt, die ein Verdrehen der Druckstücke im entlasteten Zustand verhindert. Alle Druckstücke sind auf einen durchlaufenden Draht aufgereiht.

Aus der EP 0 145 212 B1 ist außerdem ein Baugruppenträger (Verstauvorrichtung) mit Führungen für steckbare elektronische Baugruppen (Tafeln) bekannt, bei dem die Führungsmittel oder -schienen wiederum paarweise einander gegenüberliegend an der oberen und an der unteren Wand angeordnet sind. Diese Wände sind dreifach ausgestaltet, um dazwischen jeweils Räume für gasförmige oder flüssige Strömungsmittel zu schaffen, die zur Kühlung dienen. Jeweils ein Kanal für die Strömungsmittel ist auch in jeder Führungsschiene enthalten, wodurch die Wärmeableitung von den Baugruppen verbessert werden soll. Dem gleichen Zweck dienen Andruckfedern in den Führungsschienen, welche die Baugruppe gegen die gekühlte Seite drücken.

Der Erfindung liegt die Aufgabe zugrunde, herkömmliche Baugruppenträger mit Kunststoff-Führungsschienen, die für natürliche oder Zwangsbelüftung vorgesehen sind, nach Bedarf teilweise oder ganz auf Führungsschienen mit erhöhter Wärmeableitung umrüstbar zu machen. Gelöst wird diese Aufgabe durch die im Anspruch 1 angegebenen Merkmale. Eine Weiterbildung ist dem Unteranspruch zu entnehmen. Die Lösung hat den Vorteil, daß beispielsweise die in einem Gestell eingebauten Baugruppenträger unverändert bleiben können und daß lediglich die üblichen Führungsschienen durch solche mit Wärmerohr ersetzt werden müssen. Dies ist dann besonders einfach, wenn die Führungsschienen lediglich rastend im Baugruppenträger befestigt sind.

Die Erfindung wird an einem Ausführungsbeispiel beschrieben, das in der zugehörigen Zeichnung dargestellt ist. Darin zeigt:
- Fig. 1: einen Baugruppenträger für den Einbau in Gestelle, teilweise mit steckbaren Baugruppen bestückt, in perspektivischer Ansicht;
- Fig. 2: eine Führungsschiene mit Wärmerohr aus dem Baugruppenträger nach Fig. 1, in vergrößerter, perspektivischer Ansicht, sowie
- Fig. 3: eine andere Ausführung der Führungsschiene wie in Fig. 2, in perspektivischer Teilansicht.

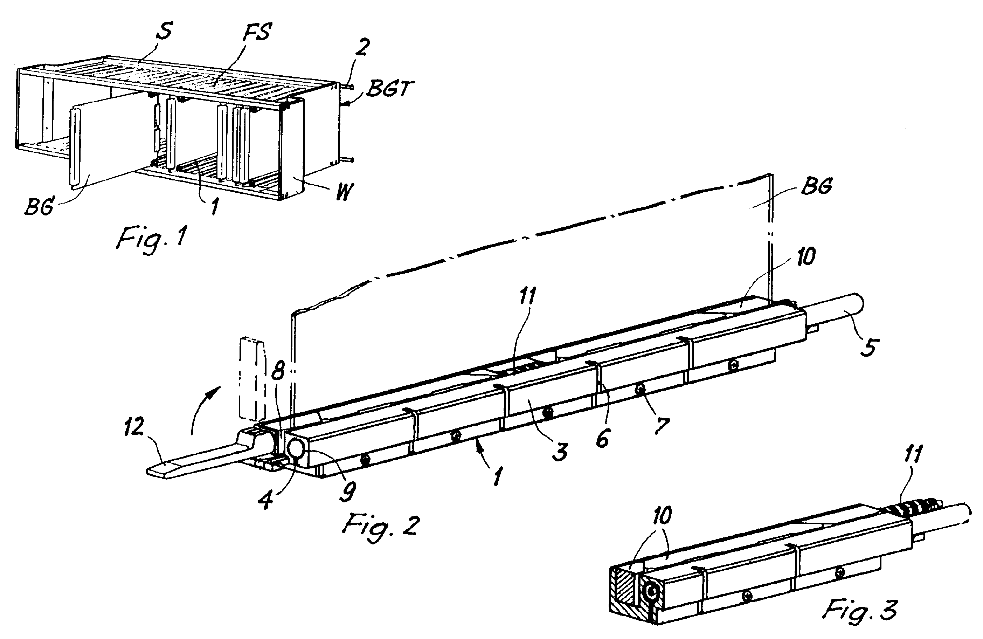

Der in Fig. 1 dargestellte Baugruppenträger BGT ist z.B. für den Einbau in Gestelle der Fernmeldetechnik vorgesehen, in denen je nach Bedarf mehrere übereiander montiert werden können. Die beiden Seitenwände W des Baugruppenträgers BGT sind an den vier Ecken durch horizontale Schienen S miteinander verbunden. An der Ober- und Unterseite des Baugruppenträgers sind innen an den horizontalen Schienen S Führungsschienen FS befestigt, die paarweise jeweils steckbare Baugruppen BG aufnehmen, welche an der Rückseite mit elektrischen Kontaktleisten ausgerüstet sind, die beim Einstecken in entsprechende Kontaktleisten an der Rückwand des Baugruppenträgers einfahren. Insoweit handelt es sich um eine herkömmliche Bauweise.

Die Verdichtung der elektrischen Bauelemente, insbesondere der leistungsstarken auf den Baugruppen BG und die damit verbundene Steigerung der Wärmeabgabe erfordert eine angemessene Kühlung. In vielen Fällen ist die bereits an die Stelle einer natürlichen Belüftung getretene Zwangsbelüftung des Gestells durch eingesetzte Lüfter nicht mehr ausreichend. Eine bessere Kühlung ist dann nur durch flüssige Kühlmittel zu erzielen.

In dem Baugruppenträger BGT sind deshalb an verschiedenen Stellen die Führungsschienen FS gegen Führungsschienen 1 mit einem Wärmerohr 5 ausgetauscht, wie sie in Fig. 2 oder 3 als Einzelteil vergrößert dargestellt sind. Dabei können den Erfordernissen entsprechend nur einige oder aber alle Führungsschienenpaare mit Wärmerohren ausgestattet sein. Die rückseitigen Enden der Wärmerohre 5 der Führungsschienen 1 können mit Querrohren 2 verbunden sein, die neben den horizontalen Schienen S auf der Rückseite des Baugruppenträgers BGT verlaufen und von einem Kühlmittel durchströmt werden.

Die Führungsschienen 1 sind zweckmäßig aus Metall gefertigt, um eine gute Wärmeübertragung zu gewährleisten. Etwa in der Mitte des Profils verläuft die Führungsnut 8 für eine Baugruppe BG, die in Fig. 2 strichpunktiert angedeutet ist. Die eine Seitenwand der Führungsnut 8 wird von einem im Querschnitt rechteckigen Profilteil 3 gebildet, das von einer parallel zur Führungsnut 8 verlaufenden Bohrung 9 zur Aufnahme des Wärmerohrs 5 durchsetzt wird. Durch einen schmalen Längsschlitz 4 ist die Bohrung 9 nach unten offen. Gleichmäßig über die Länge der Führungsschiene 1 verteilt sind mehrere Querschlitze 6, die sich von der Außenseite des Profilteils 3 bis zur Mitte der Bohrung 9 bzw. bis in den Längsschlitz 4 erstrecken. Jeweils mittig zwischen zwei Querschlitzen 6 ist unterhalb der Bohrung 9 eine Spannschraube 7 angeordnet, die den Längsschlitz 4 quer durchsetzt. Durch Festdrehen dieser Spannschraube 7 wird das Wärmerohr 5 in der Bohrung 9 festgeklemmt, wobei die Wandungen beider Teile in engen Kontakt miteinander kommen.

Die andere Seite der Führungsnut 8 wird von einer üblichen Andrückvorrichtung mit trapezförmigen Druckstücken 10, die wechselseitig in die Nut eingelegt sind, so daß sie seitlich gegeneinander verschiebbar sind. Durch ein Spannelement, z.B. eine Druckfeder 11, die entweder in der Mitte (Fig. 2) oder am rückwärtigen Ende (Fig. 3) sitzt, werden die Druckstücke 10 auch im ungespannten Zustand der Andrückvorrichtung in ihrer Lage gehalten. Das Spannen erfolgt bei eingesetzter Baugruppe BG mittels eines an der Stirnseite der Führungsschiene 1 angebrachten Hebels 12. Dieser ist an der Lagerstelle mit einem Nocken versehen, der auf das vorderste Druckstück wirkt, so daß beim Schwenken des Hebels 12 um 90° in Pfeilrichtung (Fig. 2) die Druckstücke 10 zusammen- und gegen die Baugruppe BG gepreßt werden. An der Unterseite ist die Führungsschiene 1 mit nicht dargestellten Befestigungsmitteln (Rasthaken oder dgl.) versehen, mit deren Hilfe sie im Baugruppenträger befestigbar ist.

Der Einsatz der Führungsschienen 1 mit Wärmerohr 5 hat außer einer besseren oder selektiven Kühlung von Baugruppen noch den Vorteil, daß durch Wegfall der Lüfter eine erhebliche Geräuschminderung eintritt.

## Patentansprüche

1. Baugruppenträger mit Führungsschienen zur Aufnahme steckbarer Baugruppen, insbesondere Leiterplatten-Baugruppen mit Wärmesenke, wobei die Führungsschienen jeweils auf einer Seite der Führungsnut eine Andrückvorrichtung mit trapezförmigen, gegeneinander verschiebbaren Druckstücken und einem Spannelement aufweisen,
**dadurch gekennzeichnet,**
daß die andere Seite der Führungsnut (8) von einem längsgeschlitzten Profilteil (3) gebildet wird, dessen Längsschlitz (4) parallel zur Führungsnut verläuft und am Grund in eine gleichgerichtete Bohrung (9) mündet, die ein Wärmerohr (5) enthält, und daß wenigstens eine Spannschraube (7) in dem Profilteil (3) zum Klemmen des Wärmerohrs (5) angeordnet ist, die den Längsschlitz (4) quer durchsetzt.

2. Baugruppenträger nach Anspruch 1, dadurch gekennzeichnet, daß im Profilteil (3) der Führungsschienen (1) mehrere Querschlitze (6) angebracht sind, die senkrecht zum Längsschlitz (4) bis zu dessen und der Bohrung (9) Mitte verlaufen und daß jeweils etwa mittig zwischen den Querschlitzen (6) eine Spannschraube (7) angeordnet ist.

## Claims

1. Subrack with guide rails for receiving plug-in assemblies, in particular printed-circuit board assemblies with a heat sink, each of the guide rails comprising, on one side of the guide groove, a pressure device with trapezoidal thrust members, which are displaceable relative to one another, and a clamping element,
**characterized in**
that the other side of the guide groove (8) is formed by a longitudinally slotted shaped part (3), whose longitudinal slot (4) extends parallel to the guide groove and opens at the bottom into a similarly directed bore (9) containing a heat exchanger tube (5), and that at least one clamping screw (7) which transversely penetrates the longitudinal slot (4) is disposed in the shaped part (3) for clamping the heat exchanger tube (5).

2. Subrack according to claim 1, characterized in that the shaped part (3) of the guide rails (1) is provided with a plurality of transverse slots (6), which extend perpendicular to the longitudinal slot (4) up to the centre of the latter and the centre of the bore (9), and that a clamping screw (7) is disposed approximately in the middle between each two transverse slots (6).

## Revendications

1. Porte-composants avec rails de guidage pour recevoir des composants enfichables, en particulier des composants de cartes à circuit imprimé avec radiateur, dans lequel les rails de guidage présentent chacun, d'un côté de la rainure de guidage, un dispositif de pression avec des éléments de pression en forme de trapèze, pouvant coulisser l'un par rapport à l'autre, ainsi qu'un élément de serage,
caractérisé
par le fait que l'autre côté de la rainure de guidage (8) est formé d'un profilé (3) fendu longitudinalement dont la fente longitudinale (4) est orientée parallèlement à la rainure de guidage et débouche au fond dans un perçage (9) de même orientation qui contient un tube échangeur de chaleur (5), et que dans le profilé (3), pour bloquer le tube échangeur de chaleur (5), est disposée au moins une vis de serrage (7) qui traverse transversalement la fente longitudinale (4).

2. Porte-composants selon la revendication 1, caractérisé par le fait que dans le profilé (3) des rails de guidage (1) sont prévues plusieurs fentes transversales (6) qui vont, perpendiculairement à la fente longitudinale (4), jusqu'au milieu de cette fente et au milieu du perçage (9) et qu'à peu près au milieu entre les fentes transversales (6) est chaque fois disposée une vis de serrage (7).
